# EUROPÄISCHE PATENTSCHRIFT

(11) **EP 3 771 747 B1**
(45) Veröffentlichungstag und Bekanntmachung des Hinweises auf die Patenterteilung: **30.11.2022**
(21) Anmeldenummer: 20188306.3
(22) Anmeldetag: 29.07.2020
(51) Int. Cl.: C23C 16/44, C23C 16/511, C23C 16/54, H01J 37/32

(54) **VERFAHREN UND ANLAGE ZUR KONTINUIERLICHEN VAKUUMBASIERTEN BEHANDLUNG VON BAHNWARE**
METHOD AND SYSTEM FOR CONTINUOUS VACUUM-BASED PROCESSING OF WEB MATERIAL
PROCÉDÉ ET INSTALLATION DE TRAITEMENT CONTINU À BASE DE VIDE DES MARCHANDISES EN BANDE CONTINUE

(30) Priorität: 01.08.2019 DE 102019120857
(43) Veröffentlichungstag der Anmeldung: 03.02.2021
(73) Patentinhaber: Vereinigung zur Förderung des Instituts für Kunststoffverarbeitung in Industrie und Handwerk An der Rhein.- Westf. Technischen Hochschule, 52074 Aachen (DE)
(72) Erfinder: Jaritz, Montgomery, 53332 Bornheim (DE); Dahlmann, Dr. Rainer, 52146 Würselen (DE)
(74) Vertreter: Kohlmann, Kai

(56) Entgegenhaltungen:
- EP-A1- 0 130 444
- EP-A1- 1 889 947
- EP-A2- 1 252 822
- DE-A1- 1 911 120
- US-A- 3 032 890
- US-A- 3 326 177

## Beschreibung

Die Erfindung betrifft ein Verfahren und eine Anlage zur kontinuierlichen Behandlung von elektrisch nicht leitfähiger Bahnware in einer Vakuumkammer nach den Oberbegriffen der Ansprüche 1 und 7. Die Vakuumkammer, in der die Behandlung durchgeführt wird, wird durch die Bahnware in mehrere Räume aufgetrennt, nämlich mindestens einen Raum, in dem ein Plasma gezündet wird und mindestens einen weiteren Raum, in dem kein Plasma zündet.

### Hintergrund

Mit Hilfe der plasmagestützten chemischen Gasphasenabscheidung (engl. plasma enhanced chemical vapour deposition; PECVD) können Oberflächen modifiziert und/oder dünne Funktionsschichten auf Oberflächen abgeschieden werden. Hierbei handelt es sich um ein vakuumbasiertes Behandlungsverfahren, bei dem ein Prozessgas (z.B. Hexamethyldisiloxan) im Vakuum mittels elektromagnetischer Strahlung zum Plasma angeregt wird. Bei technischen Niederdruckplasmen steigt die Prozesstemperatur durch das Vakuum nur wenig über Umgebungstemperatur, weitgehend unabhängig vom Mischungsverhältnis der Prozessgase. Dadurch können auch thermisch sensible Materialien behandelt werden.

Beispiele für die Oberflächenbehandlung sind Veränderungen der Oberflächenspannung und das Aufbringen von Gasbarriere-, Kratzschutz- und Haftvermittler- sowie Verschleißschutzschichten. Für die Verpackungsindustrie sind vor allem plasmapolymere Barrierebeschichtungen von Bedeutung. Durch die zusätzliche Barriere kann die Haltbarkeit der Produkte deutlich verlängert werden, da die Permeation von Sauerstoff, Wasserdampf und Kohlendioxid (CO₂) reduziert werden kann. Die Barriereschicht ist beispielsweise eine nur wenige Nanometer dünne SiOₓ-Barriereschicht.

Zumeist kann Material eingespart werden, da die geforderte Haltbarkeitsdauer mit gegenüber Verbundverpackungsmaterialien dünneren Verpackungsmaterialien gewährleistet werden kann. Ebenso vorteilhaft ist die Minimierung der Migration von Aromen aus und in das Verpackungsgut. Im Gegensatz zu Verbundverpackungen mit mehreren Lagen unterschiedlicher Kunststoffe, die jeweils eine spezifische Funktion erfüllen, sind Monomaterialverpackungen mit plasmapolymerer Barriereschicht recyclingfähig.

### Stand der Technik

Aus der DE 31 299 97 C2 ist bereits eine kontinuierlich arbeitende Plasma-Vakuumbehandlungsanlage mit einer Vakuumkammer zum kontinuierlichen Behandeln der Oberfläche einer Bahnware aus Kunststoff unter Vakuum bekannt. An den stromab und stromauf gelegenen Seiten der Vakuumkammer ist jeweils eine als Vorkammer ausgebildete Hilfsvakuumkammer angeordnet. Der Druck nimmt in Richtung auf die Vakuumkammer ab, wobei zwischen jeder Kammer Dichtungen angeordnet sind. Die Dichtungen sind als zwei einander berührende motorbetriebene Dichtwalzen ausgebildet sind, die eine Abdichtung gegenüber dem durchlaufenden Material, den Endoberflächen der Dichtwalzen und dem Gehäuse der Kammern bewirken. Die Vakuumkammer weist eine trommelförmige Kathode, mehrere um diese herum angeordnete Anoden und eine Führungswalze zum Führen der Bahnware auf. Die Kathode, die Anoden und die Führungswalze sind durch eine der Seitendwände der Kammer freitragend gehalten.

Bei dieser Vorrichtung muss mit Partikelentstehung und - verschleppung in der Vakuumkammer gerechnet werden. Beim Durchlaufen der Bahnware durch die Dichtwalzen kann es zum Eindrücken von Partikeln in die behandelte Bahnwarenoberfläche kommen. Weiterhin ist mit einer parasitären Beschichtung der Anoden zu rechnen. Dies wird unweigerlich zu einer hohen Frequenz notwendiger Reinigungen und damit zu hohen Stillstandzeiten der Vorrichtung führen.

Die US 2003/0134051 A1 offenbart eine kontinuierlich arbeitende Oberflächenbehandlungsanlage für durch eine Vakuumkammer laufende, elektrisch leitfähige Bahnware, bei der parasitäre Beschichtungen vermieden werden sollen. Die Bahnware, beispielsweise ein Metallband, ist als Kathode zur Zündung des Plasmas geschaltet. Das Plasma in der Vakuumkammer wird beispielsweise mit Mikrowellenfrequenzen gezündet.

Die US 2004/0149574 A1 offenbart ein Anordnung und ein Verfahren zur kontinuierlichen plasmagestützten chemischen Gasphasenabscheidung einer Beschichtung, beispielsweise einer elektrischen SiOₓ Isolationsschicht, auf einer durch eine Vakuumkammer durchlaufenden Bahnware aus Kunststoff. Die Energie zur Zündung des Plasmas wird kapazitiv in die Vakuumkammer eingekoppelt, und zwar durch zwei als Kathode geschaltete Rollen sowie zwei als Anode geschaltete Rollen. Sämtliche Rollen und damit die Elektroden sind durch die durchlaufende Bahnware abgedeckt, sodass ein parasitärer Aufbau von abgeschiedenem Material auf den Elektroden vermieden wird.

Obwohl parasitäre Beschichtungen durch die bekannt gewordenen Verfahren und Anlagen teilweise eingedämmt werden konnten, haben sich in der Praxis kontinuierlich arbeitende Verfahren und Anlagen zur Oberflächenbehandlung mittels Niederdruckplasma nicht durchgesetzt, weil vor allem der erzielte Durchsatz der Verfahren und Anlagen zu gering war.

Die EP 1 252 822 A2 offenbart ein Verfahren zur Behandlung von elektrisch nicht leitfähiger Bahnware in einer Vakuumkammer im Wege einer Plasmabehandlung. Die Vakuumkammer wird durch die Bahnware in mehrere Räume aufgeteilt, nämlich mindestens einen Raum in dem ein Plasma zündet und mindestens einen weiteren Raum, in dem kein Plasma zündet. Die Energie zur Zündung des Plasmas wird von einem Mikrowellengenerator erzeugt, der die elektromagnetische Strahlung erzeugt, die zur Zündung des Plasmas in einer Abscheideregion geeignet ist. Die Energie zur Zündung des Plasmas wird von dem Raum, in dem sich der Mikrowellengenerator befindet, in dem kein Plasma zündet, durch die Bahnware hindurch in die Abscheideregion eingestrahlt. In der Abscheideregion befindet sich der Prozessgaseinlass. Die Bahnware wird von einer Abzugsrolle über verschiedene Umlenkrollen durch die Abscheideregion hindurch bis zu einer Aufwickelrolle geführt, auf der die behandelte Bahnware aufgewickelt wird. Sämtliche vorgenannten Rollen sind in der Vakuumkammer untergebracht.

Die EP 1 889 947 A1 offenbart ein vergleichbares Verfahren und eine Anordnung zur Behandlung von elektrisch nicht leitfähiger Bahnware im Wege einer Plasmabehandlung, bei der die Mikrowellenstrahlung der Mikrowellengeneratoren durch die Bahnware hindurch in eine Vakuumkammer eingestrahlt wird und die Plasmaabscheidung auf der gegenüberliegenden Oberfläche erfolgt. Die Mikrowellengeneratoren sind in einer Stützrolle untergebracht, über die die Bahnware mit der Abscheidungsoberfläche nach außen weisend, in der Vakuumkammer geführt wird. Die Stützrolle, die Abzugsrolle für die unbehandelte Bahnware und die Aufwickelrolle für die behandelte Bahnware befinden sich in der Vakuumkammer.

### Aufgabe

Ausgehend von der EP 1 252 822 A2 als nächstliegendem Stand der Technik liegt der Erfindung die Aufgabe zugrunde, ein Verfahren zur effizienten kontinuierlichen Behandlung von Bahnware der eingangs erwähnten Art zu schaffen, bei dem eine parasitäre Abscheidung von Beschichtungsmaterial geringgehalten wird und der Durchsatz der behandelten Bahnware höher ist. Außerdem soll eine Anlage zur Durchführung des Verfahrens angegeben werden.

### Lösung

Diese Aufgabe wird durch eine Verfahren und eine Anlage mit den Merkmalen der unabhängigen Ansprüche 1 und 7 gelöst. Vorteilhafte Ausgestaltungen der Erfindung ergeben sich aus den Merkmalen der Unteransprüche.

Um die parasitäre Abscheidung von Beschichtungsmaterial gering zu halten, wird die Vakuumkammer, in der die Behandlung durchgeführt wird, erfindungsgemäß durch die Bahnware derart in mehrere Räume aufgeteilt, dass jeder Raum, in dem ein Plasma gezündet wird durch maximal zwei seitliche Innenwände der Vakuumkammer begrenzt wird. Die Aufteilung erfolgt durch eine Führung der Bahnware innerhalb der Vakuumkammer. Die Führung kann beispielsweise mittels Umlenkwalzen erfolgen. Allenfalls an den seitlichen Innenwänden, zwischen denen sich die Umlenkwalzen erstrecken, kann es zu Anlagerungen von Beschichtungsmaterial kommen.

Bestmöglich wird eine parasitäre Abscheidung von Beschichtungsmaterial vermieden, wenn die Vakuumkammer durch die Bahnware derart in mehrere Räume aufgeteilt wird, dass jeder Raum, in dem ein Plasma gezündet wird, nicht durch eine Innenwand der Vakuumkammer begrenzt wird. Der Raum wird ausschließlich durch die durchlaufende Bahnware begrenzt.

Um die Seitenwände der Vakuumkammer vor einer parasitären Beschichtung zu schützen, kann in einer Ausgestaltung der Erfindung die Plasmazone derart ausgebildet werden, dass die Breite der Plasmazone geringer als die Breite der Bahnware ist.

Die Energie zur Zündung des Plasmas wird durch mindestens einen Signalgenerator erzeugt, der elektromagnetische Strahlung mit einer Frequenz erzeugt, die zur Zündung des Plasmas geeignet ist. Die Energie zur Zündung des Plasmas wird von einem Raum, in dem kein Plasma zündet, mittels des Signalgenerators durch die Bahnware hindurch in einen Raum mit Plasmazündung eingestrahlt.

Die Einkopplung der Energie zur Zündung des Plasmas mittels des Signalgenerators bewirkt, dass an der Oberfläche der Bahnware eine höhere Energiedichte als bei den bisher bekannten Verfahren erzeugt wird. Die höhere Energiedichte erlaubt einen höheren Durchsatz bei der kontinuierlichen Behandlung der Bahnware, insbesondere weil die Bahnware mit höherer Geschwindigkeit durch die Vakuumkammer hindurchbewegt werden kann.

Für die Zündung des Plasmas kommt in erster Linie das Mikrowellenband, jedoch auch das HF-Band in Betracht. Der Signalgenerator ist daher vorzugsweise als Mikrowellen- oder HF-Generator ausgestaltet.

Das Verfahren erlaubt eine kontinuierliche Behandlung von elektrisch nicht leitfähiger Bahnware. Nicht leitfähig bezeichnet eine dielektrische Bahnware, die insbesondere eine elektrische Leitfähigkeit von weniger als 10⁻⁸ S · cm⁻¹ sowie einem spezifischen Widerstand von über 10⁸ Ω · cm aufweist.

Unter Behandlung werden sowohl eine Beschichtung wie auch eine abscheidefreie, oberflächenmodifizierende Behandlung der Bahnware verstanden. Höhere Behandlungsintensitäten führen in diesem Sinne zu einem höheren Durchsatz bzw. einer höheren Abscheiderate.

Das in der Vakuumkammer erzeugte Plasma ist ein Niederdruckplasma, in dem der Druck erheblich niedriger als der Erdatmosphärendruck ist. Technische Niederdruckplasmen werden in einem Druckbereich weniger Pascal betrieben, also bei Drücken, die um einen Faktor 10.000 geringer sind als der atmosphärische Luftdruck.

In vorteilhafter Ausgestaltung der Erfindung ist jeder Signalgenerator als Modul ausgeführt. In dem Modul sind die Komponenten zur Generierung und Einstrahlung der elektromagnetischen Strahlung zusammengefasst. Jedes Modul wird ausschließlich in dem mindestens einen weiteren Raum angeordnet, in dem kein Plasma zündet. Durch diese Anordnung, wird wirksam eine parasitäre Beschichtung des Signalgenerators vermieden.

In jeden Raum, in dem ein Plasma zündet, wird ein Prozessgas eingeleitet. Die Energie zur Plasmazündung wird mittels des Signalgenerators von außen durch die Bahnware hindurch in das Prozessgas eingekoppelt, so dass das Plasma in direkter Nachbarschaft der Oberfläche der Bahnware zündet. Die maximale Energie und somit die maximal erzielbare Behandlungsintensität liegt auf der zu behandelnden Oberfläche der Bahnware vor. Die Energie der elektromagnetischen Strahlung nimmt quadratisch mit dem Abstand zu den Komponenten zur Einstrahlung der elektromagnetischen Strahlung des Signalgenerators ab. Jede Einstrahlungskomponente kann nah an der der zu behandelnden Oberfläche gegenüberliegenden, rückwärtigen Seite der Bahnware angeordnet sein.

Sofern auf der Bahnware eine Beschichtung im Wege der plasmagestützten chemischen Gasphasenabscheidung aufgebracht werden soll, wird als Prozessgas vorzugsweise ein gasförmiges, Monomere enthaltendes Prozessgas in jeden Raum eingeleitet, in dem das Plasma zündet.

Nachfolgend wird die Erfindung anhand der Figuren näher erläutert. Es zeigen
- **Figur 1**: eine Anlage mit gleichzeitiger Einschleusung der Bahnware in zwei getrennten Bahnen und Ausschleusung der behandelten Bahnen ohne Oberflächenberührung und
- **Figur 2**: eine Anlage mit Einschleusung der Bahnware in nur einer Bahn und Ausschleusung der behandelten Bahn mit Oberflächenberührung.

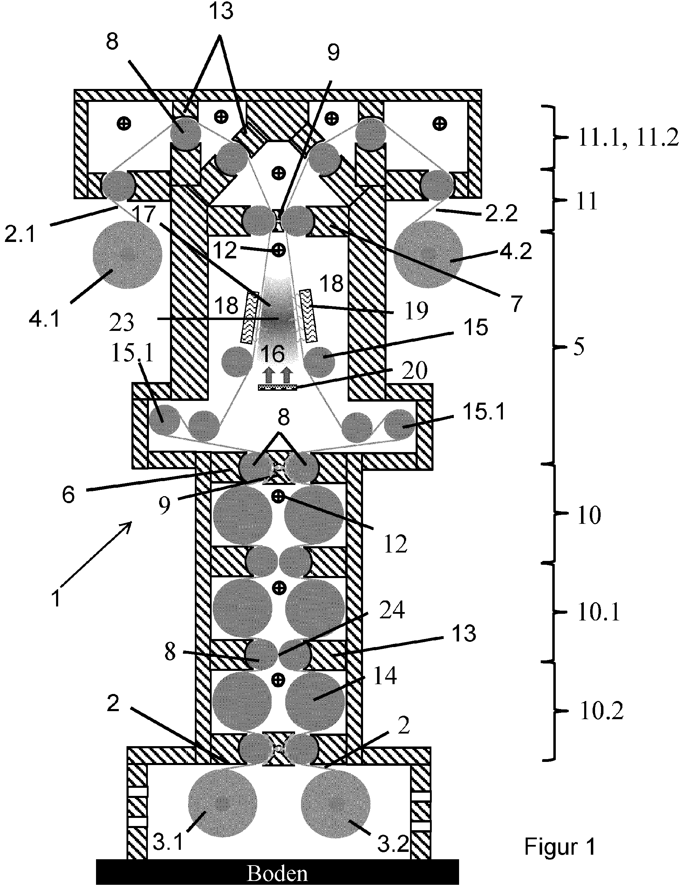

Figur 1 zeigt eine Anlage (1) zur kontinuierlichen Beschichtung von Bahnware (2). Die Bahnware (2) besteht aus elektrisch nicht leitfähigen Verpackungskunststoffen, wie PE, PET oder PP. Die Bahnware (2) wird in zwei voneinander getrennten Bahnen (2.1, 2.2) in einem Rolle-zu-Rolle Prozess beim Durchlauf durch die Anlage (1) mit einer nur wenige Nanometer starken SIOₓ-Barriereschicht ausgerüstet. Die unbeschichteten Bahnen (2.1, 2.2) werden von den einlaufseitigen Rollen (3.1, 3.2) abgezogen und nach dem Beschichten auf die auslaufseitigen Rollen (4.1, 4.2) aufgewickelt.

Die plasmagestützte chemische Gasphasenabscheidung der Barriereschicht erfolgt in einer Vakuumkammer (5). Einlaufseitig weist die Vakuumkammer (5) eine Schleuse (6) zum Einschleusen der beiden Bahnen (2.1, 2.2) in die Vakuumkammer (5) und auslaufseitig eine weitere Schleuse (7) zum Ausschleusen der der beiden Bahnen (2.1, 2.2) aus der Vakuumkammer (5) auf. Die Vakuumkammer (5) ist über die einlauf- und auslaufseitige Schleuse (6, 7) jeweils mit einer als Zwischenstufe ausgebildeten ersten Vorkammer (10, 11) gasdicht verbunden. Der ersten Vorkammer (10) sind zwei weitere Vorkammern (10.1, 10.2) vorgeordnet. Der ersten Vorkammer (11) an der Auslaufseite sind ebenfalls weitere Vorkammern (11.1, 11.2) vorgeordnet, und zwar jeweils zwei für jede Bahn (2.1, 2.2).

Jede Vorkammer (10, 10.1, 10.2, 11, 11.1, 11.2) und die Vakuumkammer (5) sind über einen Anschluss (12) mit einer nicht dargestellten Vakuumpumpe verbunden, über die der zur plasmagestützten chemischen Gasphasenabscheidung erforderliche Niederdruck in der Vakuumkammer (5) erzeugt und aufrechterhalten wird.

Zwischen den einzelnen Vorkammern (10, 10.1, 10.2, 11, 11.1, 11.2) sind jeweils Schleusen mit (13) mit Schleusenwalzen (8) angeordnet, über die die Bahnen (2.1, 2.2) der Bahnware (2) geführt werden. Den Spalt (24) zwischen den Schleusenwalzen (8) können die Bahnen (2.1, 2.2) passieren, ohne sich gegenseitig zu berühren. Der Spalt (24) ist so dimensioniert, dass sich in den unterschiedlichen Vorkammern (10, 10.1, 10.2, 11, 11.1, 11.2) unterschiedlich hohe Niederdruckniveaus aufrechterhalten lassen. Hierdurch lässt sich ausgehend von den äußeren Vorkammern (10.2, 11.2) in Richtung der Vakuumkammer (5) der Druck sequenziell absenken mit Vorteil für die benötigte Leistung der Vakuumpumpe zur Erzeugung des benötigten Niederdrucks in der Vakuumkammer (5).

Eine Sperrgasbarriere (9) in der ein- und auslaufseitigen Schleuse (6,7) reduziert die Diffusion von schichtbildenden Radikalen zwischen der Vakuumkammer (5) und den Vorkammern (10, 10.1, 10.2, 11, 11.1, 11.2).

In den einlaufseitigen Vorkammern (10, 10.1, 10.2) sind als Umlenkwalzen (14) ausgebildete Führungen der Bahnen (2.1, 2.2) innerhalb der Vorkammern (10, 10.1, 10.2) drehbar gelagert. Die Umlenkwalzen (14) erstrecken sich zwischen den in der Bildebene liegenden, die Vorkammern begrenzenden Seitenwänden und bewirken, dass die beiden Bahnen (2.1, 2.2) weitgehend ohne zu flattern und ohne sich gegenseitig zu berühren durch die Vorkammern (10, 10.1, 10.2) hindurchbewegt werden können.

In der Vakuumkammer (5) sind als Umlenkwalzen (15, 15.1) ausgeführte Führungen vorgesehen, die sich zwischen den in den Bildebene liegenden, die Vakuumkammer (5) begrenzenden Seitenwänden erstrecken. Durch die Umlenkwalzen (15, 15.1) werden die beiden Bänder (2.1, 2.2) hinter der einlaufseitigen Schleuse (6) im Abstand zueinander durch die Vakuumkammer geführt. Die derart geführten Bänder (2.1, 2.2) teilen die Vakuumkammer (5) in drei Räume auf, nämlich einen Raum (16), in dem Plasma zündet und zwei weitere Räume (18), in denen kein Plasma zündet. Die Räume (16, 18) werden durch die Bahnen (2.1, 2.2), die sich über die gesamte Breite der Umlenkwalzen (15) erstrecken, sowie die Seitenwände der Vakuumkammer (5) begrenzt. In den beiden weiteren Räumen (18), in denen kein Plasma zündet, befindet sich jeweils ein Signalgenerator (19). Jeder Signalgenerator (19) weist eine Komponente zur Generierung und eine Komponente zur Einstrahlung elektromagnetischer Strahlung (17) auf. Die elektromagnetische Strahlung (17) wird im Mikrowellenband erzeugt. Im dargestellten Ausführungsbeispiel sind die beiden Signalgeneratoren (19) als Modul ausgeführt, welches beide Komponenten des Signalgenerators (19) umfasst. Alternativ kann in den beiden weiteren Räumen (18) jeweils lediglich die Komponente zur Einstrahlung der Mikrowellenstrahlung (17) angeordnet sein, während die Komponente zur Generierung der Mikrowellenstrahlung außerhalb der Vakuumkammer (5) angeordnet ist. Die Mikrowellenstrahlung (17) kann von dem Generator beispielsweise über einen Hohlleiter in die beiden weiteren Räume (18) ohne Plasmazündung geleitet werden. Der Hohlleiter weist an einem Ende Schlitze auf, über die die elektromagnetische Strahlung eingestrahlt wird. Die Strahlung aus der Komponente zur Generierung wird an dem anderen Ende des Hohlleiters beispielsweise über ein PTFE-Fenster eingekoppelt, so dass über den Hohlleiter kein Druckausgleich stattfindet.

In dem Raum (16) mit Plasmazündung ist ein Verteiler mit einem Einlass (20) für ein Prozessgas angeordnet. Das Prozessgas ist ein gasförmige Monomere enthaltendes Gas, zum Beispiel Hexamethyldisiloxan. In das Prozessgas wird mittels der elektromagnetischen Strahlung (17) der Signalgeneratoren (19) die Energie zur Zündung eingestrahlt. Die Einstrahlung erfolgt durch die Bahnen (2.1, 2.2) hindurch in den Raum (16), wo sich eine Plasmazone (23) ausbildet. Das Abscheidematerial zur Ausbildung der Barriereschicht wird nahezu ausschließlich auf der Oberfläche der Bahnware (2) abgeschieden. Unerwünschte Beschichtungen von Anlagenteilen werden weitgehend verhindert. Lediglich die Gasverteilung mit dem Einlass (20) für das Prozessgas (20) wird mit beschichtet, wobei die Abscheiderate aufgrund der Anordnung des Gasverteilers außerhalb der Plasmazone (23) deutlich geringer ist, als auf den Bahnen (2.1, 2.2) selbst. Darüber hinaus ist der Gasverteiler gut zugänglich und kann schnell getauscht bzw. gereinigt werden. Die höchste Energie, der höchste Ionisierungsgrad und damit die maximal erzielbare Abscheiderate wird direkt auf den Oberfläche der zu beschichtenden Bahnen (2.1, 2.2) erzielt. Die Umlenkwalzen (15) in der Vakuumkammer (5) sind derart angeordnet, dass diese ebenfalls nicht beschichtet werden, weil sie durch die Bahnen (2.1, 2.2) abgedeckt werden. Lediglich die beiden äußeren Führungswalzen (15.1) werden durch die Bahnen (2.1, 2.2) gegenüber dem Raum (16) mit Plasmazündung nicht abgedeckt. Diese äußeren Führungswalzen (15.1) sind jedoch in einem maximalen Abstand zu den Signalgeneratoren (19) innerhalb der Vakuumkammer (5) und weitgehend abgedeckt durch die benachbart angeordneten Führungswalzen (15) angeordnet, so das eine parasitäre Abscheidung von Beschichtungsmaterial auf den Mantelflächen der äußeren Führungswalzen (15.1) wirksam verhindert wird.

Um die Seitenwände der Vakuumkammer vor einer parasitären Beschichtung zu schützen, kann in einer Ausgestaltung der Erfindung die Plasmazone (23) geringer als die Breite der Bahnware (2) sein. Auf die Ausbildung der Plasmazone (23) kann durch Verändern der Anordnung und Geometrie der Komponente zur Einstrahlung der elektromagnetischen Strahlung des Signalgenerators (19) Einfluss genommen werden.

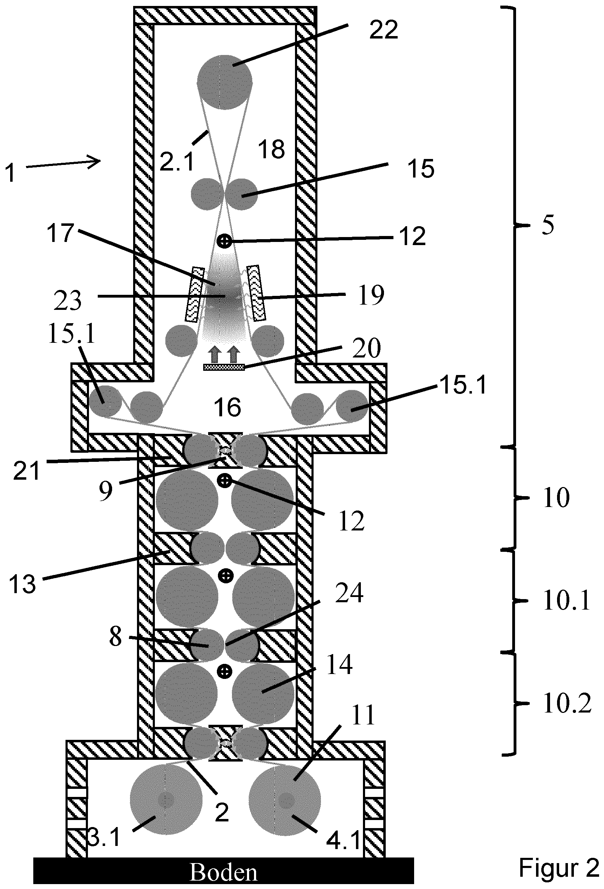

Die beschichteten Bahnen (2.1, 2.2) laufen nach der Beschichtung ausschließlich über die in den Schleusen (7, 13) angeordneten Umlenkwalzen (14). Die beschichteten Bahnen (2.1, 2.2) liegen ausschließlich mit der der beschichteten Oberfläche gegenüberliegenden Seite auf den Umlenkwalzen (14) auf. Ein Vorteil der berührungslosen Führung besteht darin, dass eine Defekteinbringung durch Eindrücken von Partikeln beim Ausschleusen weitgehend ausgeschlossen ist. Dieser Vorteil wird jedoch bei diesem Anlagenkonzept durch den Nachteil erkauft, dass aufgrund der ein- und auslaufseitigen Schleusen (6, 7) eine höhere Pumpleistung zur Erzeugung und Aufrechterhaltung des Niederdrucks in der Vakuumkammer (5) benötigt wird als bei einem Anlagenkonzept, wie es nachfolgend anhand der Figur 2 erläutert wird.

Das Anlagenkonzept nach Figur 2 unterscheidet sich im Wesentlichen von dem Anlagenkonzept nach Figur 1 dadurch, dass die Ein- und Ausschleusung nur einer Bahn (2.1) der Bahnware (2) über eine Schleuse (21) erfolgt, die an der Unterseite der Vakuumkammer (5) angeordnet. Über die in Figur 2 links dargestellte Schleusenwalze (8) läuft die nur eine Bahn (2.1) der Bahnware (2) in die Vakuumkammer (5) ein, wird am oberen Umkehrpunkt über eine Umlenkwalze (22) umgelenkt und läuft über die im Bild rechte Schleusenwalze (8) der Schleuse (21) aus der Vakuumkammer (5) heraus. Im Übrigen stimmt der Aufbau der Vakuumkammer (5) mit derjenigen nach Figur 1 weitgehend überein, so dass auf die Ausführungen zu der Anlage nach Figur 1 verwiesen wird. Auch die Kaskade der einlaufseitigen Vorkammern (10, 10.1, 10.2) stimmt in Aufbau und Wirkungsweise mit den Vorkammern (10, 10.1, 10.2) der Anlage nach Figur 1 überein. Abweichend zu dem Ausführungsbeispiel nach Figur 1 befindet sich die auslaufseitige Rolle (4.1), auf die die beschichtete Bahnware (2) aufgewickelt wird, neben der einlaufseitigen Rolle (3.1), von der die unbeschichtete Bahnware (2) abgezogen wird.

Aufgrund der Führung der beschichteten Bahnware (2) über die Umlenkwalze (22), die rechte Umlenkwalze (15.1) in der Vakuumkammer (5) sowie die Umlenkwalzen (14) in den Vorkammern (10, 10.1, 10.2) gelangt die beschichtete Oberfläche der durchlaufenden Bahnware (2) mit den Mantelflächen der vorgenannten Umlenkwalzen in Kontakt. Der Nachteil des Anlagenkonzepts gegenüber dem nach Figur 1 besteht daher darin, dass eine Defekteinbringung durch Eindrücken von Partikeln auftreten kann. Gegenüber dem Anlagenkonzept nach Figur 1 wird jedoch lediglich eine geringere Pumpleistung zur Erzeugung und Aufrechterhaltung des Niederdrucks in der Vakuumkammer (5) benötigt.

**Bezugszeichenliste**

| **Nr.** | **Bezeichnung** |
|---|---|
| 1. | Anlage |
| 2. | Bahnware |
| 2.1 | Bahn |
| 2.2 | Bahn |
| 3.1 | Einlaufseitige Rolle |
| 3.2 | Einlaufseitige Rolle |
| 4.1 | Auslaufseitige Rolle |
| 4.2 | Auslaufseitige Rolle |
| 5. | Vakuumkammer |
| 6. | Schleuse zum Einschleusen |
| 7. | Schleuse zum Ausschleusen |
| 8 . | Schleusenwalzen |
| 9. | Sperrgasbarriere |
| 10. | Erste Vorkammer |
| 10.1 | Vorkammer |
| 10.2 | Vorkammer |
| 11. | Erste Vorkammer |
| 11.1 | Vorkammer |
| 11.2 | Vorkammer |
| 12. | Anschluss |
| 13. | Schleusen |
| 14. | Führung/Umlenkwalze |
| 15. | Führung /Umlenkwalze |
| 15.1 | Äußere Führung /Umlenkwalze |
| 16. | Raum mit Plasmazündung |
| 17. | Elektromagnetische Strahlung |
| 18. | Raum ohne Plasmazündung |
| 19. | Signalgenerator |
| 20. | Einlass Prozessgas |
| 21. | Schleuse zum Ein- und Ausschleusen |
| 22. | Umlenkwalze |
| 23. | Plasmazone |
| 24. | Spalt |

## Patentansprüche

1. Verfahren zur kontinuierlichen Behandlung von elektrisch nicht leitfähiger Bahnware (2) in einer Vakuumkammer (5), wobei die Vakuumkammer (5), in der die Behandlung durchgeführt wird, durch die Bahnware (2) in mehrere Räume(16,18) aufgeteilt wird, nämlich mindestens einen Raum (16), in dem ein Plasma zündet und mindestens einen weiteren Raum (18), in dem kein Plasma zündet, wobei
- die Energie zur Zündung des Plasmas durch mindestens einen Signalgenerator (19) erzeugt wird, der elektromagnetische Strahlung (17) mit einer Frequenz erzeugt, die zur Zündung des Plasmas geeignet ist,
- und die Energie zur Zündung des Plasmas von dem mindestens einen Raum (18), in dem kein Plasma zündet, durch die Bahnware (2) hindurch in einen Raum (16) mit Plasmazündung eingestrahlt wird,
**dadurch gekennzeichnet, dass**
- die Bahnware (2) durch die Vakuumkammer (5) kontinuierlich hindurchbewegt wird und
- die Vakuumkammer (5) durch die Bahnware (2) derart in mehrere Räume (16,18) aufgeteilt wird, dass jeder Raum (16), in dem ein Plasma gezündet wird, durch maximal zwei seitliche Innenwände der Vakuumkammer (5) begrenzt wird.

2. Verfahren nach Anspruch 1, **dadurch gekennzeichnet, dass** jeder Signalgenerator (19) als Modul ausgeführt ist in dem die Komponenten zur Generierung und Einstrahlung der elektromagnetischen Strahlung (17) zusammengefasst sind und jedes Modul ausschließlich in dem mindestens einen weiteren Raum (18) angeordnet wird, in dem kein Plasma zündet.

3. Verfahren nach Anspruch 1 oder 2, **dadurch gekennzeichnet, dass** jeder Signalgenerator (19) elektromagnetische Wellen im Mikrowellenband und/oder HF-Band erzeugt.

4. Verfahren nach einem der Ansprüche 1 bis 3, **dadurch gekennzeichnet, dass** ein Prozessgas in jeden Raum (16) eingeleitet wird, in dem ein Plasma zündet.

5. Verfahren nach Anspruch 4, **dadurch gekennzeichnet, dass** ein gasförmige Monomere enthaltendes Prozessgas eingeleitet wird.

6. Verfahren nach einem der Ansprüche 1 bis 5, **dadurch gekennzeichnet, dass** die Bahnware (2) eine oder mehrere durch die Vakuumkammer hindurchbewegte Bahn(en) (2.1, 2.2) umfasst.

7. Anlage (1) zur kontinuierlichen Behandlung von elektrisch nicht leitfähiger Bahnware (2) umfassend
- eine Vakuumkammer (5), in der die Behandlung durchgeführt wird,
- die elektrisch nicht leitfähige Bahnware (2),
- in der Vakuumkammer (5) angeordnete Führungen (15) für die Bahnware (2), die derart angeordnet sind, dass die durch die Vakuumkammer (5) laufende Bahnware (2) die Vakuumkammer (5) in mehrere Räume (16,18) aufteilt, nämlich mindestens einen Raum (16), in dem ein Plasma zündet und mindestens einen weiteren Raum (18), in dem kein Plasma zündet,
- die Anlage (1) mindestens einen Signalgenerator (19) mit einer Komponente zur Generierung und einer Komponente zur Einstrahlung elektromagnetischer Strahlung (17) aufweist, wobei die elektromagnetische Strahlung (17) mit einer Frequenz erzeugt wird, die zur Zündung des Plasmas geeignet ist,
- zumindest jede Komponente zur Einstrahlung in dem mindestens einen weiteren Raum (18), in dem kein Plasma zündet, derart angeordnet ist, dass die Energie zur Zündung des Plasmas durch die Bahnware (2) hindurch in den mindestens einen Raum (16), in dem ein Plasma zündet, eingestrahlt wird
**dadurch gekennzeichnet, dass**
- die in der Vakuumkammer (5) angeordneten Führungen (15) für die Bahnware (2) weiter derart angeordnet sind, dass jeder Raum (16), in dem ein Plasma gezündet wird durch maximal zwei seitliche Innenwände der Vakuumkammer begrenzt wird.

8. Anlage nach Anspruch 7, **dadurch gekennzeichnet, dass** jeder Signalgenerator (19) als Modul ausgeführt ist in dem die Komponenten zur Generierung und Einstrahlung der elektromagnetischen Strahlung (17) zusammengefasst sind und jedes Modul ausschließlich in dem mindestens einen weiteren Raum (18) angeordnet wird, in dem kein Plasma zündet.

9. Anlage nach Anspruch 7 oder 8, **dadurch gekennzeichnet, dass** jeder Signalgenerator (19) zur Erzeugung elektromagnetischer Strahlung (17) im Mikrowellenband und/oder HF-Band eingerichtet ist.

10. Anlage nach einem der Ansprüche 7 bis 9, **dadurch gekennzeichnet, dass** in jedem Raum (16), in dem ein Plasma zündet, ein Einlass (20) für ein Prozessgas angeordnet ist.

11. Anlage nach einem der Ansprüche 7 bis 10, **dadurch gekennzeichnet, dass**
- die Anlage (1) eine Schleuse (6) zum Einschleusen der Bahnware (2) in die Vakuumkammer (5) und eine weitere Schleuse (7) zum Ausschleusen der Bahnware (2) aus der Vakuumkammer (5) aufweist,
- die Vakuumkammer (5) über die Schleusen (6, 7) jeweils mit einer ersten Vorkammer (10, 11) gasdicht verbunden sind, wobei jede erste Vorkammer (10, 11) und die Vakuumkammer (5) über einen Anschluss (12) mit mindestens einer Vakuumpumpe verbindbar ist.

12. Anlage nach einem der Ansprüche 7 bis 10, **dadurch gekennzeichnet, dass**
- die Anlage (1) nur eine Schleuse (21) zum Ein - und Ausschleusen der Bahnware (2) in die Vakuumkammer (5) aufweist,
- die Vakuumkammer über die eine Schleuse (21) mit einer ersten Vorkammer (10) gasdicht verbunden ist, wobei die erste Vorkammer (10) und die Vakuumkammer (5) über einen Anschluss (12) mit mindestens einer Vakuumpumpe verbindbar sind.

13. Anlage nach Anspruch 11 oder 12, **dadurch gekennzeichnet, dass** jede Schleuse (6,7,21) zwischen der Vakuumkammer (5) und der ersten Vorkammer (10,11) eine Sperrgasbarriere (9) aufweist.

14. Anlage nach einem der Ansprüche 11 - 13, **dadurch gekennzeichnet, dass**
- jeder ersten Vorkammer (10, 11) mindesten eine weitere Vorkammer (10.1, 10.2,11.1, 11.2) vorgelagert ist,
- zwischen sämtlichen Vorkammern (10, 10.1, 10.2, 11,11.1, 11.2) Schleusen (13) angeordnet sind, die die Vorkammern gasdicht miteinander verbinden und
- jede weiter Vorkammer (10.1, 10.2,11.1, 11.2) über einen Anschluss (12) mit der mindestens einen Vakuumpumpe verbindbar ist.

15. Anlage nach einem der Ansprüche 11 - 14, **dadurch gekennzeichnet, dass** sämtliche Schleusen (6, 7, 13, 21) Schleusenwalzen (8) aufweisen, die zur Führung der Bahnware (2) zwischen den Kammern eingerichtet sind.

16. Anlage nach einem der Ansprüche 7 bis 15, **dadurch gekennzeichnet, dass** Teile der Anlage (1) mit einer positiven oder negativen Vorspannung derart beaufschlagt werden, dass geladene schichtbildende Radikale aus dem Plasma abgestoßen werden.

## Claims

1. Method for the continuous processing of electrically non-conductive web material (2) in a vacuum chamber (5), wherein the vacuum chamber (5) in which the processing is carried out is divided by the web material (2) into several chambers (16, 18), namely at least one chamber (16) in which a plasma is ignited and at least one further chamber (18) in which no plasma is ignited, wherein
- the energy for igniting the plasma is generated by at least one signal generator (19), which generates electromagnetic radiation (17) at a frequency which is suitable for igniting the plasma,
- and the energy for igniting the plasma is emitted from the at least one chamber (18) in which no plasma is ignited through the web material (2) into a chamber (16) with plasma ignition,
**characterized in that**
- the web material (2) is moved continuously through the vacuum chamber (5) and
- the vacuum chamber (5) is divided by the web material (2) into several chambers (16, 18) in such a manner that each chamber (16) in which a plasma is ignited is delimited by a maximum of two lateral internal walls of the vacuum chamber (5) .

2. Method according to Claim 1, **characterized in that** each signal generator (19) is designed as a module in which the components for generating and emitting the electromagnetic radiation (17) are combined and each module is exclusively arranged in the at least one further chamber (18) in which no plasma is ignited.

3. Method according to Claim 1 or 2, **characterized in that** each signal generator (19) generates electromagnetic waves in the microwave band and/or HF band.

4. Method according to one of Claims 1 to 3, **characterized in that** a process gas is introduced into each chamber (16) in which a plasma is ignited.

5. Method according to Claim 4, **characterized in that** a process gas containing gaseous monomers is introduced.

6. Method according to one of Claims 1 to 5, **characterized in that** the web material (2) comprises one or more web(s) (2.1, 2.2) moved through the vacuum chamber.

7. System (1) for continuous processing of electrically non-conductive web material (2) comprising
- a vacuum chamber (5) in which the processing is carried out,
- the electrically non-conductive web material (2),
- guides (15) for the web material (2) arranged in the vacuum chamber (5) which are arranged in such a manner that the web material (2) running through the vacuum chamber (5) divides the vacuum chamber (5) into several chambers (16, 18), namely at least one chamber (16) in which a plasma is ignited and at least one further chamber (18) in which no plasma is ignited,
- the system (1) comprises at least one signal generator (19) with a component for generating and a component for emitting electromagnetic radiation (17), wherein the electromagnetic radiation (17) is generated at a frequency which is suitable for igniting the plasma,
- at least each component for emission in the at least one further chamber (18) in which no plasma is ignited is arranged in such a manner that the energy for ignition of the plasma is emitted through the web material (2) into the at least one chamber (16) in which a plasma is ignited,
**characterized in that**
- the guides (15) arranged in the vacuum chamber (5) for the web material (2) are further arranged in such a manner that each chamber (16) in which a plasma is ignited is delimited by a maximum of two lateral internal walls of the vacuum chamber.

8. System according to Claim 7, **characterized in that** each signal generator (19) is executed as a module in which the components for generating and emitting the electromagnetic radiation (17) are combined and each module is exclusively arranged in the at least one further chamber (18) in which no plasma is ignited.

9. System according to Claim 7 or 8, **characterized in that** each signal generator (19) is adapted for generating electromagnetic radiation (17) in the microwave band and/or HF band.

10. System according to one of Claims 7 to 9, **characterized in that** an inlet (20) for a process gas is arranged in each chamber (16) in which a plasma is ignited.

11. System according to one of Claims 7 to 10, **characterized in that**
- the system (1) has a lock (6) for loading the web material (2) into the vacuum chamber (5) and a further lock (7) for unloading the web material (2) from the vacuum chamber (5),
- the vacuum chambers (5) are connected via the locks (6, 7) in each case to a first pre-chamber (10, 11) in a gas-tight manner, wherein each first pre-chamber (10, 11) and the vacuum chamber (5) can be connected to at least one vacuum pump via a connection (12).

12. System according to one of Claims 7 to 10, **characterized in that**
- the system (1) has only one lock (21) for loading and unloading the web material (2) into the vacuum chamber (5),
- the vacuum chamber is connected via the one lock (21) to the first pre-chamber (10) in a gastight manner, wherein the first pre-chamber (10) and the vacuum chamber (5) can be connected via a connection (12) to at least one vacuum pump.

13. System according to Claim 11 or 12, **characterized in that** each lock (6, 7, 21) has a blocking gas barrier (9) between the vacuum chamber (5) and the first pre-chamber (10, 11).

14. System according to one of Claims 11-13, **characterized in that**
- at least one further pre-chamber (10.1, 10.2, 11.1, 11.2) is mounted upstream of each first pre-chamber (10, 11),
- locks (13) are arranged between all the pre-chambers (10, 10.1, 10.2, 11, 11.1, 11.2) which connect the pre-chambers to one another in a gastight manner and
- each further pre-chamber (10,1, 10.2, 11.1, 11.2) can be connected via a connection (12) to the at least one vacuum pump.

15. System according to one of Claims 11-14, **characterized in that** all the locks (6, 7, 13, 21) have lock rollers (8) which are adapted for guidance of the web material (2) between the chambers.

16. System according to one of Claims 7 to 15, **characterized in that** parts of the system (1) are subjected to a positive or negative bias voltage in such a manner that charged layer-forming radicals are expelled from the plasma.

## Revendications

1. Procédé, destiné à traiter en continu un produit en bande (2) électrique non conducteur, dans une chambre à vide (5), la chambre à vide (5) dans laquelle le traitement est réalisé étant divisé par le produit en bande (2) en plusieurs espaces (16, 18), à savoir au moins un espace (16), dans lequel un plasma est allumé, et au moins un espace (18) supplémentaire, dans lequel aucun plasma n'est allumé,
- l'énergie pour allumer le plasma étant générée par au moins un générateur de signaux (19), qui génère un rayonnement électrique (17) à une fréquence qui est adaptée pour allumer le plasma,
- et l'énergie pour allumer le plasma étant irradiée par l'au moins un espace (18) dans lequel aucun plasma n'est allumé, à travers le produit en bande (2) dans un espace (16) avec allumage du plasma,
**caractérisé en ce que**
- le produit en bande (2) est déplacé en continu à travers la chambre à vide (5), et
- la chambre à vide (5) est divisée en plusieurs espaces (16, 18) par le produit en bande (2), de telle sorte que chaque espace (16) dans lequel un plasma est allumé soit délimité par un maximum de deux parois internes latérales de la chambre à vide (5).

2. Procédé selon la revendication 1, **caractérisé en ce que** chaque générateur de signaux (19) est conçu sous la forme d'un module, dans lequel les composants destinés à générer et à irradier la rayonnement électromagnétique (17) sont rassemblés et chaque module est placé exclusivement dans l'au moins un espace (18) supplémentaire, dans lequel aucun plasma n'est allumé.

3. Procédé selon la revendication 1 ou 2, **caractérisé en ce que** chaque générateur de signaux (19) génère des ondes électromagnétiques dans la bande des micro-ondes et/ou dans la bande HF.

4. Procédé selon l'une quelconque des revendications 1 à 3, **caractérisé en ce que** l'on introduit un gaz de processus dans chaque espace (16) dans lequel un plasma est allumé.

5. Procédé selon la revendication 4, **caractérisé en ce que** l'on introduit un gaz de processus contenant un monomère gazeux.

6. Procédé selon l'une quelconque des revendications 1 à 5, **caractérisé en ce que** le produit en bande (2) comprend une ou plusieurs bande(s) (2.1, 2.2) déplacées à travers la chambre à vide.

7. Installation (1), destiné au traitement en continu d'un produit en bande (2) électrique non conducteur électrique, comprenant :
- une chambre à vide (5), dans laquelle le traitement est réalisé,
- le produit en bande (2) non conducteur électrique,
- des guidages (15) placés dans la chambre à vide (5) pour le produit en bande (2), qui sont placés de telle sorte que le produit en bande (2) qui traverse la chambre à vide (5) divise la chambre à vide (5) en plusieurs espaces (16, 18), à savoir au moins un espace (16), dans lequel un plasma est allumé, et au moins un espace (18) supplémentaire, dans lequel aucun plasma n'est allumé,
- l'installation (1) comportant au moins un générateur de signaux (19), pourvu d'un composant pour la génération et d'un composant pour l'irradiation d'un rayonnement électromagnétique (17), le rayonnement électromagnétique (17) étant généré avec une fréquence qui est adaptée pour allumer le plasma,
- au moins chaque composant pour l'irradiation dans l'au moins un espace supplémentaire (18), dans lequel aucun plasma n'est allumé étant placé de telle sorte que l'énergie destinée à allumer le plasma soit irradiée à travers le produit en bande (2) dans l'au moins un espace (16) dans lequel aucun plasma n'est allumé,
**caractérisée en ce que**
- les guidages (15) placés dans la chambre à vide (5) pour le produit en bande (2) sont placés par ailleurs de telle sorte, que chaque espace (16) dans lequel un plasma est allumé soit délimité au maximum par deux parois internes latérales de la chambre à vide.

8. Installation selon la revendication 7, **caractérisée en ce que** chaque générateur de signaux (19) est conçu sous la forme d'un module, dans lequel les composants destinés à générer et à irradier la rayonnement électromagnétique (17) sont rassemblés et chaque module est placé exclusivement dans l'au moins un espace (18) supplémentaire, dans lequel aucun plasma n'est allumé.

9. Installation selon la revendication 7 ou 8, **caractérisée en ce que** chaque générateur de signaux (19) est aménagé pour générer un rayonnement électromagnétique (17) dans la bande des micro-ondes et/ou dans la bande HF.

10. Installation selon l'une quelconque des revendications 7 à 9, **caractérisée en ce que** dans chaque espace (16) dans lequel un plasma est allumé est placée une entrée (20) pour un gaz de processus.

11. Installation selon l'une quelconque des revendications 7 à 10, **caractérisée en ce que**
- l'installation (1) comporte un sas (6), destiné à faire pénétrer le produit en bande (2) dans la chambre à vide (5) et un sas (7) supplémentaire, destiné à faire sortir le produit en bande (2) de la chambre à vide (5),
- les chambres à vide (5) sont reliées chacune de manière étanche au gaz, par l'intermédiaire des sas (6, 7) avec une première préchambre (10, 11), chaque première préchambre (10, 11) et la chambre à vide (5) étant susceptibles d'être reliées par l'intermédiaire d'un raccord (12) avec au moins une pompe à vide.

12. Installation selon l'une quelconque des revendications 7 à 10, **caractérisée en ce que**
- l'installation (1) ne comporte qu'un sas (21) pour faire pénétrer et faire sortir le produit en bande (2) dans la chambre (5),
- la chambre à vide est reliée de manière étanche au gaz par l'intermédiaire de l'un sas (21) avec une première préchambre (10), la première préchambre (10) et la chambre à vide (5) étant susceptibles d'être reliées par l'intermédiaire d'un raccord (12) avec au moins une pompe à vide.

13. Installation selon la revendication 11 ou 12, **caractérisée en ce que** chaque sas (6, 7, 21) comporte entre la chambre à vide (5) et la première préchambre (10, 11) une barrière (9) aux gaz d'étanchéité.

14. Installation selon l'une quelconque des revendications 11 à 13, **caractérisée en ce que**
- en amont de chaque première préchambre (10, 11) est montée au moins une préchambre (10.1, 10.2, 11.1, 11.2) supplémentaire,
- entre toutes les préchambres (10, 10.1, 10.2, 11, 11.1, 11.2) sont placés des sas (13), qui relient entre elles les préchambres de manière étanche au gaz et
- chaque préchambre (10.1, 10.2, 11.1, 11.2) supplémentaire est susceptible d'être reliée par l'intermédiaire d'un raccord (12) avec l'au moins une pompe à vide.

15. Installation selon l'une quelconque des revendications 11 à 14, **caractérisée en ce que** tous les sas (6, 7, 13, 21) comportent des rouleaux de transfert (8), qui sont aménagés pour guider le produit en bande (2) entre les chambres.

16. Installation selon l'une quelconque des revendications 7 à 15, **caractérisée en ce que** des parties de l'installation (1) sont soumises à une précontrainte positive ou négative, de telle sorte que des radicaux chargés formant des couches soit expulsés hors du plasma.
